# EUROPEAN PATENT APPLICATION

(11) **EP 4 425 543 A1**
(43) Date of publication of application: **04.09.2024**
(21) Application number: 22907237.6
(22) Date of filing: 01.12.2022
(51) Int. Cl.: H01L 23/36, H01L 23/40, H05K 1/02, H05K 7/20

(54) **MOUNTING BOARD, AND ELECTRIC APPARATUS EQUIPPED WITH MOUNTING BOARD**

(30) Priority: 14.12.2021 JP 2021202290
(71) Applicant: OMRON Corporation, Kyoto 600-8530 (JP)
(72) Inventor: MISHIMA, Junya, Kyoto-shi, Kyoto 600-8530 (JP); OMURA, Eiichi, Kyoto-shi, Kyoto 600-8530 (JP); YANAI, Kentaro, Kyoto-shi, Kyoto 600-8530 (JP); URATA, Shimpei, Kyoto-shi, Kyoto 600-8530 (JP); SHIMOZATO, Kazufumi, Kyoto-shi, Kyoto 600-8530 (JP)
(74) Representative: Isarpatent
(86) International application number: PCT/JP2022/044453
(87) International publication number: WO 2023/112709

(57) **Abstract**

To provide a mounting board that can prevent, when a printed circuit board on which an electronic component is mounted is screwed to a heat sink, occurrence of a short circuit between a bonding material and the electronic component or between the printed circuit board and the electronic component, and damage to the electronic component due to strain in the printed circuit board caused by contact between the printed circuit board and the electronic component, as well as an electric apparatus equipped with the mounting board. The mounting board includes an electronic component, a printed circuit board, a heat spreader, and a heat dissipation component. A first insulating member and a second insulating member each being an insulator are arranged between the electronic component and the heat spreader and between the heat spreader and the heat dissipation component, respectively, and a hardness of the first insulating member and a hardness of the second insulating member are lower than a hardness of the heat spreader.

## Description

### TECHNICAL FIELD

The present invention relates to a mounting board and an electric apparatus equipped with the mounting board.

### BACKGROUND ART

As a related-art technology, a semiconductor device capable of greatly enhancing the heat dissipation ability of an electronic component is known. The semiconductor device includes an electronic component, a board on which the electronic component is mounted, a lower housing equipped with the board, and a heat spreader having a first surface to which the electronic component is metal-bonded via a bonding material. The lower housing has an opening portion with which the heat spreader is engaged, and the heat spreader is bonded to the opening portion via a bonding material. A second surface of the heat spreader opposed to the first surface is located outside the lower housing (see Patent Document 1, for example).

In addition, there is also known a heat dissipation structure for a semiconductor device in which heat generated by the semiconductor device is transferred from a heat dissipation surface of the semiconductor device via a non-insulating member to an electrically conductive highly thermally conductive member at which the heat diffuses, and the heat is further transferred to a heat dissipation component via a first insulating member. The semiconductor device has an electric bonding surface electrically connected with a substrate and a heat dissipation surface on an opposite side of the electric bonding surface. In the heat dissipation structure, the heat dissipation surface is bonded or placed into contact with an electrically conductive highly thermally conductive member via a non-insulating member, and the electrically conductive highly thermally conductive member is bonded or placed into contact with the heat dissipation component via the first insulating member (see, for example, Patent Document 2).

### CITATION LIST

### PATENT LITERATURE

Patent Document 1: JP 2014-003258 A
Patent Document 2: JP 2017-191904 A

### SUMMARY OF INVENTION

### TECHNICAL PROBLEM

In the semiconductor device as disclosed in Patent Document 1, an electronic component is bonded to a heat spreader having an ability to diffuse heat into the atmosphere, via a bonding material. This significantly improves heat dissipation from the electronic component which generates a large amount of heat in response to a current flow. In addition, for example, a board on which an electronic component is mounted may be screwed to a heat spreader to more closely bond the electronic component and the heat spreader via a bonding material. However, there are cases where a heat dissipation pad and the heat spreader are electrically connected to each other due to the non-insulating nature of the bonding material, and a sufficient insulation distance between a terminal of the electronic component and the heat spreader cannot be provided. In the heat dissipation structure as disclosed in Patent Document 2, a non-insulating component is arranged between a semiconductor device and a heat spreader, and an insulating component is arranged between the heat spreader and a heat sink. However, in a case where the hardness of the non-insulating component or the insulating component is high, a large strain may be caused in the board when the board on which the semiconductor device is mounted is screwed to the heat sink, and a component such as a ceramic capacitor mounted on the board may become damaged due to the strain.

The present invention has been made in view of the above-described problems, and the ultimate object of the present invention is to provide a mounting board that can prevent, when a printed circuit board (corresponding to the above-described board) on which an electronic component (corresponding to the above-described semiconductor device) is mounted is screwed to a heat sink, occurrence of a short circuit between a heat spreader and a terminal of the electronic component, and damage to the electronic component due to strain in the printed circuit board, as well as an electric apparatus equipped with the mounting board.

### SOLUTION TO PROBLEM

The present invention for solving problems described above is a mounting board, including, an electronic component including an electronic element, a package surrounding the electronic element, and a heat dissipation pad having heat dissipation ability, a printed circuit board, on which the electronic component is mounted via a terminal connected to an external circuit, a heat spreader including a metal as a main component, to which heat generated in the electronic component is transferred, and a heat dissipation component including a metal as a main component, to which heat from the heat spreader is further transferred to be dissipated into air, in which a first insulating member and a second insulating member each being an insulator are arranged between the electronic component and the heat spreader and between the heat spreader and the heat dissipation component, respectively, and a hardness of the first insulating member and a hardness of the second insulating member are lower than a hardness of the heat spreader.

According to the present invention, the first insulating member for heat dissipation is an insulator, and thus it is possible to prevent a short circuit from occurring even if the terminal is positioned near the heat spreader due to a force applied to the mounting board. In addition, since the first and second insulating members have a low hardness and are highly deformable, the first and second insulating members can be preferentially deformed when a force is applied to the mounting board. Thus, deformation of the board is suppressed. Further, in a case where the electronic component is mounted on the printed circuit board via the lead with a certain distance therebetween, a decrease in the distance between the electronic component and the printed circuit board is suppressed. Further, the first insulating member arranged between the heat dissipation pad of the electronic component and the heat spreader makes it possible to suppress a short circuit between the terminal of the electronic component and the heat spreader.

In the mounting board according to the present invention, the hardness of the first insulating member according to Asker C hardness standard may be in a range from Asker C 5 to Asker C 50. This configuration makes it possible to suppress a strain in the printed circuit board when the printed circuit board is attached to the heat dissipation component. From the viewpoint of suppressing strain, the hardness of the first insulating member is more preferably in a range from Asker C 5 to Asker C 20.

In the mounting board according to the present invention, the first insulating member may have a thickness in a range from 0.2 mm to 0.8 mm. Similarly to the above-described configuration, this configuration also makes it possible to suppress strain in the printed circuit board when the printed circuit board is attached to the heat dissipation component. From the viewpoint of suppressing strain, it is more preferable that the first insulating member have a thickness in a range from 0.2 mm to 0.3 mm.

In the mounting board according to the present invention, the area of the heat spreader may be 2 times or more and 7 times or less the area of the heat dissipation pad. This configuration facilitates close contact between the electronic component and the heat spreader via the first insulating member, and makes it possible to suppress strain in the printed circuit board when the printed circuit board is attached to the heat dissipation component. In addition, this configuration facilitates transfer of heat generated in the electronic component, to the heat spreader via the heat dissipation pad and the first insulating member, and further heat transfer to the second insulating member. From the viewpoint of improving the heat dissipation ability, it is preferable that the area of the heat spreader be 2 times or more and 4 times or less the area of the heat dissipation pad. From the viewpoint of suppressing strain, it is preferable that the area of the heat spreader be 4 times or more and 6 times or less the area of the heat dissipation pad.

In the mounting board according to the present invention, the thermal conductivity of the first insulating member may be higher than the thermal conductivity of the second insulating member. This configuration improves transfer efficiency of the heat generated in the electronic component and transferred to the heat spreader.

In the mounting board according to the present invention, the first insulating member may have a thermal conductivity in a range from 3 W/mK to 20 W/mK. Similarly to the above-described configuration, this configuration improves the transfer efficiency of the heat transferred from the heat generated in the electronic component, to the heat spreader. From the viewpoint of improving the heat dissipation ability, it is preferable that the first insulating member have a thermal conductivity in a range from 3 W/mK to 8 W/mK.

In the mounting board according to the present invention, the heat spreader may have a thickness in a range from 0.3 mm to 1.0 mm. This configuration facilitates heat transfer from the heat spreader to the heat dissipation component via the second insulating member. Thus, this configuration is preferable from the viewpoint of improving heat dissipation ability.

In the mounting board according to the present invention, the first insulating member may be connected to the heat dissipation pad of each of a plurality of the electronic components. This configuration provides a simple structure allowing for heat dissipation from the plurality of electronic components on the printed circuit board, and thus can reduce the size and cost of the mounting board.

According to the present invention, an electric apparatus that performs power conversion of power supplied from a power supply device, and that is equipped with the above-described mounting board, may be provided. This configuration makes it possible to diffuse generated heat from a cooling structure portion into the air outside the electric apparatus and to perform cooling at the electric apparatus by using the outside air. Further, the electric apparatus can be equipped with a circuit pattern of the printed circuit board.

Note that the above-described means for solving the problems can be combined as long as the combination is possible.

### ADVANTAGEOUS EFFECTS OF INVENTION

According to the present invention, in a mounting board, when a printed circuit board on which an electronic component is mounted is assembled, it is possible to prevent occurrence of a short circuit between a heat dissipation pad and a terminal of the electronic component, or damage to the electronic component due to strain in the printed circuit board.

### BRIEF DESCRIPTION OF DRAWINGS

[FIG. 1] FIG. 1 is a schematic cross-sectional view of an example of a mounting board according to a first embodiment of the present invention.
[FIG. 2] FIG. 2 is a schematic cross-sectional view of the mounting board according to the first embodiment of the present invention, illustrating how a printed circuit board with an electronic component mounted thereon is screwed to a heat sink.
[FIG. 3] FIG. 3A and FIG. 3B are tables showing results of a comparative evaluation, in terms of thermal resistance, of the mounting boards according to the first embodiment of the present invention, which have different characteristic values of the first insulating member and the heat spreader.
[FIG. 4] FIG. 4A and FIG. 4B are tables showing results of a comparative evaluation, in terms of strain in the printed circuit board, of the mounting boards according to the first embodiment of the present invention, which have different characteristic values of the first insulating member and the heat spreader.
[FIG. 5] FIG. 5 is a schematic cross-sectional view of an example of a power conditioner equipped with the mounting board according to the first embodiment of the present invention.
[FIG. 6] FIG. 6 is a schematic cross-sectional view of a mounting board according to a second embodiment of the present invention, illustrating how a printed circuit board with an electronic component mounted thereon is screwed to a heat sink.

### DESCRIPTION OF EMBODIMENTS

### [Application Example]

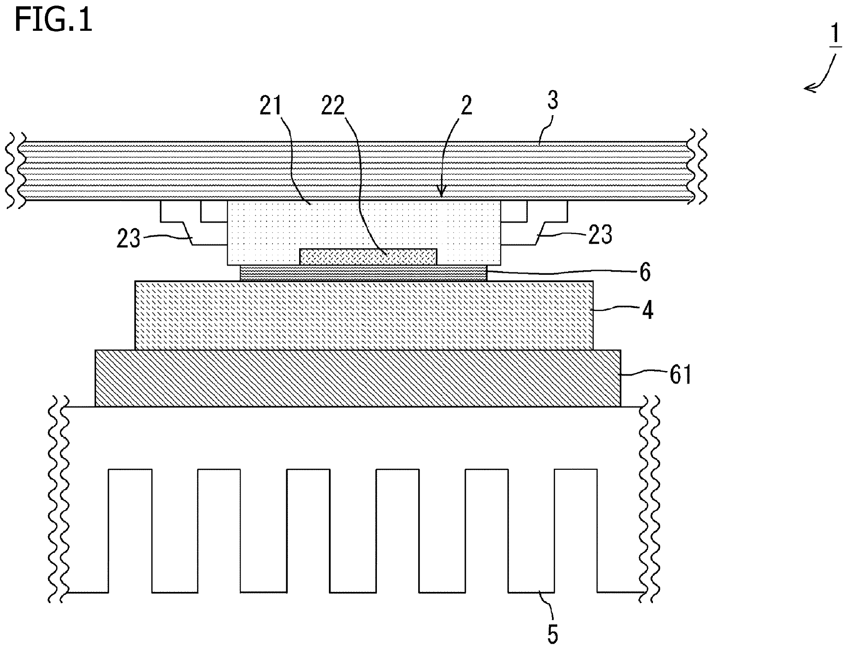

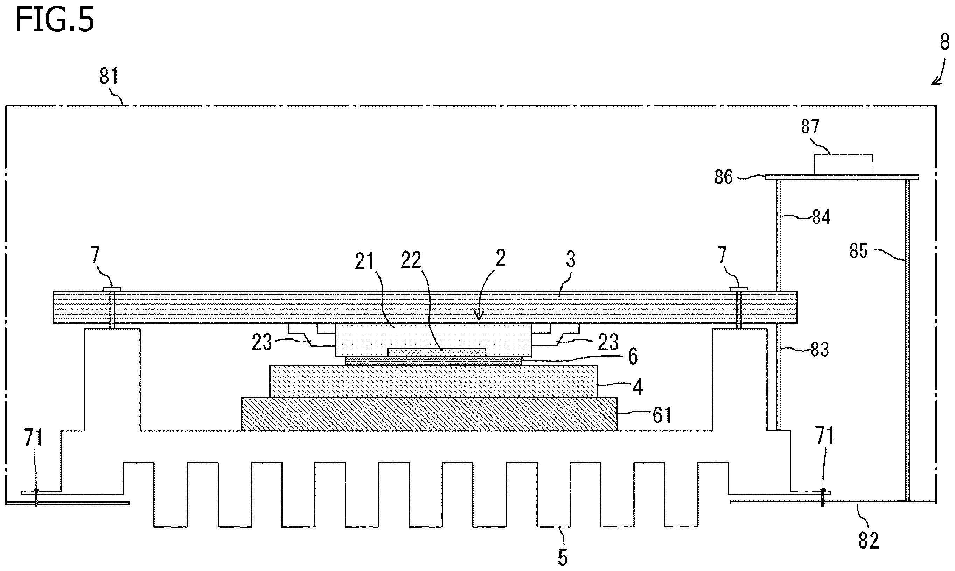

Hereinafter, an application example of the present invention will be generally described with reference to some of the drawings. The present invention can be applied to a mounting board 1 as illustrated in FIG. 1. Further, the present invention can also be applied to a power conditioner 8 (corresponding to an electric apparatus in the present invention) as illustrated in FIG. 5 by providing the mounting board 1, as illustrated in FIG. 1, in the power conditioner 8.

FIG. 1 is a schematic cross-sectional view of an example of the mounting board 1 to which the present invention is applied. The mounting board 1 according to this application example includes an electronic component 2, a printed circuit board 3, a heat spreader 4, a heat sink 5, and the like. Examples of the electronic component 2 include a semiconductor component such as an application specific integrated circuit (ASIC) and a power semiconductor such as a metal oxide semiconductor field effect transistor (MOSFET). The electronic component 2 includes an electronic element (not illustrated), a package 21 formed so as to surround the electronic element, and a heat dissipation pad 22 having heat dissipation ability. The heat dissipation pad 22 is formed integrally with a lead 23 on which a semiconductor chip using, for example, gallium nitride (GaN) is mounted. When a current flows through the electronic element, the electronic component 2 generates heat. Although the mounting board 1 includes other electronic components (e.g., a capacitor) in addition to the electronic component 2, the electronic component 2 generates a larger amount of heat than the other electronic components.

The lead 23 serving as a terminal connected to an external circuit extends from the inside to the outside of the package 21 of the electronic component 2, and a part of the lead 23 is formed in a gull-wing shape. One end of the lead 23 is electrically connected to the printed circuit board 3 (specifically, an electrode or the like formed on a surface of the printed circuit board 3) via, for example, solder paste (not illustrated). In the case illustrated in FIG. 1, the electronic component 2 is mounted so as to be in contact with the printed circuit board 3. The printed circuit board 3 may be, for example, a build-up printed wiring board having a multilayer structure and including a thermosetting epoxy resin as a base material.

The heat spreader 4 includes, as a main component, a metal such as aluminum and has a thermal conductivity of about 190 W/mK. The heat generated in the electronic component 2, as described above, is transferred to the heat spreader 4 via the heat dissipation pad 22 and a first insulating member 6 described below. The area of the heat spreader 4 is larger than the area of the heat dissipation pad 22. The heat sink 5 also includes a metal such as aluminum as a main component. The heat absorbed by the heat spreader 4 is further transferred, via a second insulating member 61 described below, to the heat sink 5, at which the transferred heat diffuses to the surroundings, for example, the outside air. The thermal conductivity of the heat spreader 4 is much higher than those of the first insulating member 6 and the second insulating member 61. This facilitates heat transfer from the first insulating member 6 to the second insulating member 61. Here, the heat sink 5 corresponds to a heat dissipation component in the present invention.

The first insulating member 6 and the second insulating member 61 are, for example, sheet-like insulators made of silicone or the like. The first insulating member 6 is disposed between the electronic component 2 and the heat spreader 4, and the second insulating member 61 is disposed between the heat spreader 4 and the heat sink 5. To achieve closer bonding between the electronic component 2, the heat spreader 4, and the heat sink 5, adhesive members may be employed as the first insulating member 6 and the second insulating member 61.

In this application example, the characteristic values of the first insulating member 6 and the second insulating member 61 are as follows. The first insulating member 6 has a thickness of 0.3 mm, a thermal conductivity of 8 W/mK, and a hardness of Asker C 20. Asker C is a type of standard for expressing hardness. The second insulating member 61 has a thickness of 1.0 mm, a thermal conductivity of 1 W/mK, and a hardness of Asker C 20. The hardness of the first insulating member 6 and the second insulating member 61 is lower than the hardness of the heat spreader 4. The thermal conductivity of the first insulating member 6 is higher than the thermal conductivity of the second insulating member 61. Note that the above-described characteristic values are examples, and the present invention is not limited to the characteristic values as long as these conditions are satisfied.

### [First Embodiment]

Hereinafter, the mounting board 1 according to a first embodiment of the present invention and the power conditioner 8 as an example of the electric apparatus will be described in more detail with reference to the drawings. Note that the mounting board 1 and the power conditioner 8 according to the present invention are not limited to the following configurations.

### <Configuration of Mounting Board>

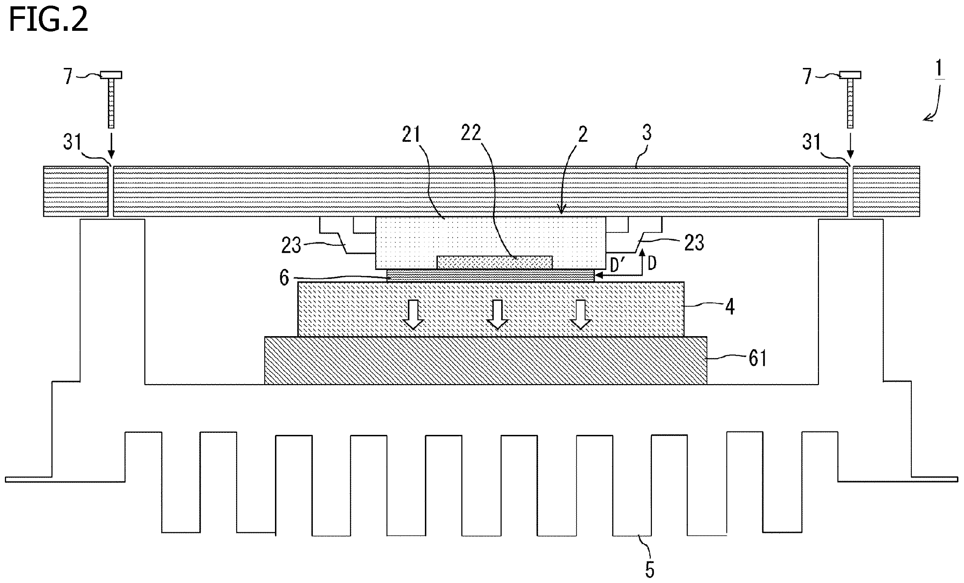

FIG. 2 is a schematic cross-sectional view of the mounting board 1 according to the first embodiment of the present invention, illustrating how the printed circuit board 3 with the electronic component 2 mounted thereon is screwed to the heat sink 5. The printed circuit board 3 has a plurality of screw holes 31. The printed circuit board 3 can be fixed to the heat sink 5 by inserting screws 7 through the screw holes 31 and tightening the screws 7. The lead 23 is spaced from the first insulating member 6 by a distance D in the vertical direction and a distance D' in the horizontal direction in FIG. 2 (hereinafter, the distance D and the distance D' are collectively referred to as "insulation distance"). Here, although the insulation distance is for ensuring that the lead 23 and the first insulating member 6 are at a certain distance from each other, there is a possibility that the lead 23 or the first insulating member 6 is deformed by a force generated due to screwing and thus the lead 23 and the first insulating member 6 come into contact with each other. Therefore, if a non-insulating heat dissipation member is used instead of the first insulating member 6, a short circuit between the lead 23 and the heat dissipation member may occur. In addition, if the heat spreader 4 made of metal is bonded to the heat dissipation pad 22 via a non-insulating heat dissipation member, the heat spreader 4 will have the same potential as the heat dissipation pad 22, the insulation distance between the lead 23 and the first insulating member 6 will become short, and thus a short circuit may occur due to creeping discharge, space discharge, or the like.

In contrast, the first insulating member 6 is an insulator in the present embodiment, as described in the above-described application example, and thus, even if a force generated due to screwing brings the lead 23 into contact with the first insulating member 6, it is possible to prevent occurrence of a short circuit. In addition, the hardness of the first insulating member 6 and the second insulating member 61 is lower than the hardness of the heat spreader 4. Therefore, the second insulating member 61 is highly deformable and easily absorbs the force generated due to screwing (arrows illustrated in FIG. 2 indicate the force) including a force generated from the heat spreader 4 having a relatively high hardness. As a result of deformation of the second insulating member 61, deformation of the first insulating member 6 and the printed circuit board 3 is suppressed, and thus reduction of the insulation distance is also suppressed. As a result, it is possible to prevent the lead 23 and the first insulating member 6 from coming into contact with each other due to screw tightening. The relatively large thickness of the second insulating member 61 also contributes to absorption of the force generated due to screwing.

The second insulating member 61 can largely deform in response to application of a force, compared to the heat sink 5 that is less deformable. Thus, by pressing the heat spreader 4 against the second insulating member 61, intimate contact of the heat spreader 4 can be easily achieved compared with a case where the heat spreader 4 is directly pressed against the heat sink 5. Such close contact facilitates heat transfer from the heat spreader 4. As a result, the amount of heat which diffuses from the heat sink 5 to the surroundings also increases. Further, since the first insulating member 6 arranged in contact with the heat dissipation pad 22 is relatively thin and has a relatively high thermal conductivity, the heat generated by the electronic component 2 is easily transferred to the heat spreader 4.

### <Examples of Verification of Effect>

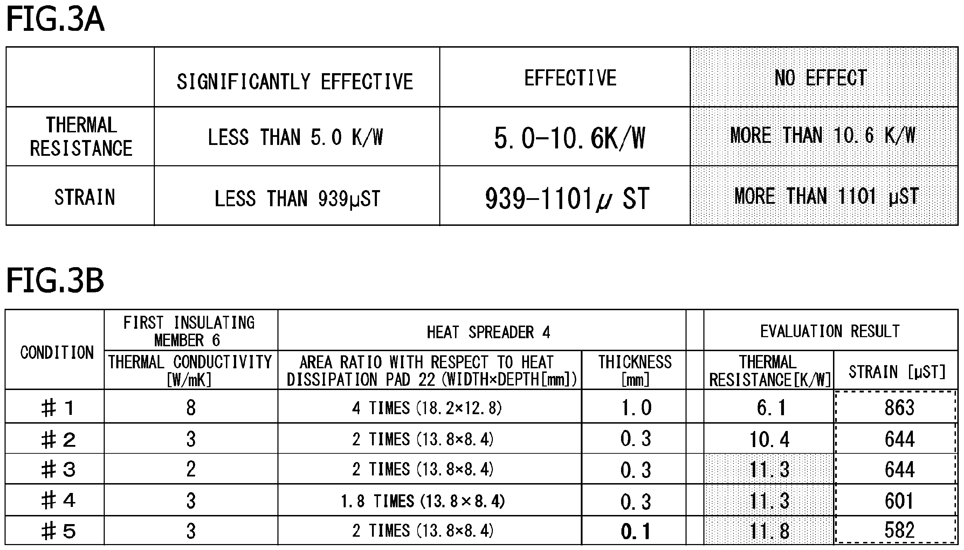

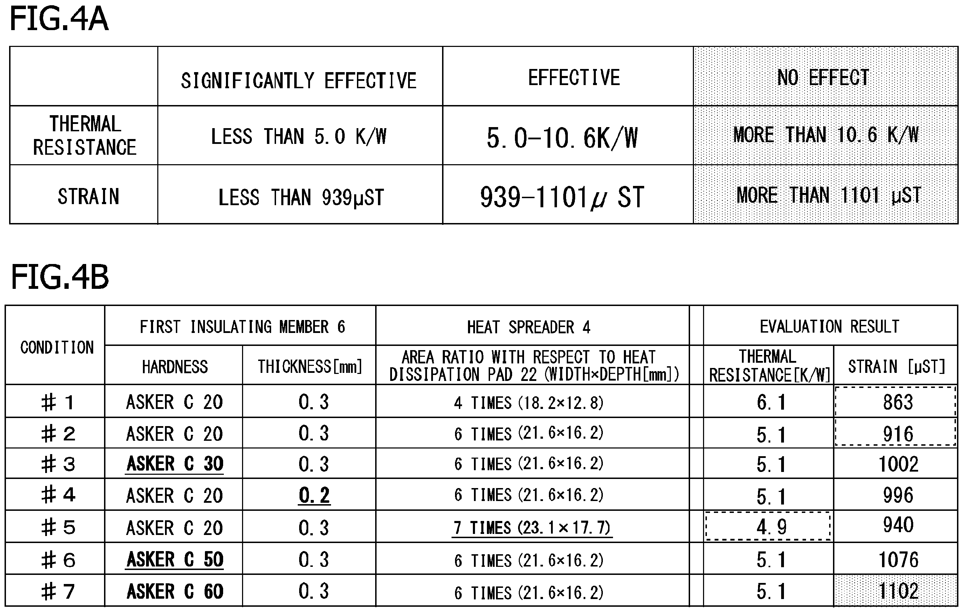

FIG. 3A and FIG. 3B are tables showing results of a comparative evaluation, in terms of thermal resistance, of the mounting boards 1 according to the first embodiment of the present invention, which have different characteristic values of the first insulating member 6 and the heat spreader 4. FIG. 4A and FIG. 4B are tables showing results of a comparative evaluation, in terms of strain in the printed circuit board 3, of the mounting boards 1 according to the first embodiment of the present invention, which have different characteristic values of the first insulating member 6 and the heat spreader 4. Here, in the evaluation of thermal resistance, a good value is defined as a thermal resistance in a range from 5.0 K/W to 10.6 K/W ("effective" in FIG. 3A and FIG. 4A), a better value is defined as a thermal resistance of less than 5.0 K/W ("significantly effective" in FIG. 3A and FIG. 4A), and a value at which no significant effect is achieved is defined as a thermal resistance of more than 10.6 K/W ("no effect" in FIG. 3A and FIG. 4A). Similarly, in the evaluation of the strain in the printed circuit board 3 (hereinafter simply referred to as "strain"), a good value is defined as a strain in a range from 939 µST to 1101 µST, a better value is defined as a strain of less than 939 µST, and a value at which no significant effect is achieved is defined as a strain of 1101 µST.

In FIG. 3B, the mounting board 1 associated with a condition #1 has a standard configuration. Under a condition #2, a smaller strain and a higher thermal resistance are exhibited as compared with the condition #1. Under the condition #2, the thermal resistance is close to the upper limit (10.6 K/W) of the range of good values. Here, the mounting board 1 associated with the condition #2 can be regarded as a configuration having an effect of improving the heat dissipation ability. Under conditions #3 to #5, high thermal resistances are exhibited, which indicate that the conditions #3 to #5 are inferior to the condition #1 in terms of heat dissipation ability. In comparison with the other conditions, under the condition #3, the thermal conductivity (2 W/mK) of the first insulating member 6 is the lowest, under the condition #4, the area ratio (1.8 times) of the heat spreader 4 to the heat dissipation pad 22 is the smallest, and under the condition #5, the thickness (0.1 mm) of the heat spreader 4 is the thinnest. Note that under all conditions, better strain values are exhibited.

In FIG. 4B, the mounting board 1 associated with the condition #1 has a standard configuration. Under the condition #2, a lower thermal resistance and a large strain are exhibited as compared with the condition #1. Under the condition #2, the strain is close to the upper limit (939 µST) of the range of better values. Here, the mounting board 1 associated with the condition #2 can be regarded as a configuration having an improvement effect in terms of strain. Under the conditions #3 to #5, larger strains are exhibited than in the case of the condition #2, which are from better values to good values. As compared with the condition #2, under the condition #3, the hardness of the first insulating member 6 is higher, under the condition #4, the thickness of the first insulating member 6 is thinner, and under the condition #5, the area ratio of the heat spreader 4 to the heat dissipation pad 22 is larger. Under condition #6, the hardness of the first insulating member 6 is even higher than in the case of the condition #3, and a larger strain value is exhibited. Under condition #7, the hardness (Asker C 60) of the first insulating member 6 is the highest, as compared with the other conditions, and a strain value at which no significant effect is achieved.

The result of the comparative evaluation in terms of thermal resistance shown in FIG. 3A and FIG. 3B indicates that it is preferable that the first insulating member 6 of the mounting board 1 according to the first embodiment of the present invention have a thermal conductivity in a range from 3 W/mK to 8 W/mK. The first insulating member 6 may have a thermal conductivity in a range from 3 W/mK to 20 W/mK. It is preferable that the heat spreader 4 have a thickness in a range from 0.3 mm to 1.0 mm. The result of the comparative evaluation in terms of strain shown in FIG. 4A and FIG. 4B indicates that it is preferable that the first insulating member 6 of the mounting board 1 according to the first embodiment of the present invention have a hardness in a range from Asker C 20 to Asker C 50. It is more preferable that the first insulating member 6 have a hardness in a range from Asker C 5 to Asker C 20. It is preferable that the first insulating member 6 have a thickness in a range from 0.2 mm to 0.3 mm. The first insulating member 6 may have a thickness in a range from 0.2 mm to 0.8 mm. The result of the comparative evaluation of FIG. 3A and FIG. 3B indicates that the preferable area ratio of the heat spreader 4 to the heat dissipation pad 22 is 2 times or more and 4 times or less, whereas the result of the comparative evaluation of FIG. 4A and FIG. 4B indicates that a preferable area ratio of the heat spreader 4 to the heat dissipation pad 22 is 4 times or more and 7 times or less, and a more preferable area ratio is 4 times or more and 6 times or less.

### <Configuration of Power Conditioner>

FIG. 5 is a schematic cross-sectional view of an example of the power conditioner 8 equipped with the mounting board 1 according to the first embodiment of the present invention. An electric apparatus may be equipped with the mounting board 1, and examples of the electric apparatus may include a power conversion device such as the power conditioner 8, a motor driving apparatus, and a power supply apparatus. The power conditioner 8 is connected to a power supply device (not illustrated) such as a photovoltaic cell, increases a voltage of power supplied from the power supply device, converts the power into alternating current power, removes noise to shape a waveform, and then supplies the alternating current power to a load (not illustrated) or an interconnected power system (not illustrated).

A thermally conductive metal base 82 is provided on a side surface of a housing 81 of the power conditioner 8. The heat sink 5 connected with the printed circuit board 3 is screwed to the metal base 82 by using second screws 71. A part of the heat sink 5 is exposed to the outside of the housing 81, and thus heat generated in the electronic component 2 is easily transferred to the outside air.

The screws 7 are used to screw the printed circuit board 3 to the heat sink 5. In addition, a base 86 is screwed to the printed circuit board 3, the metal base 82, and the heat sink 5 via the spacers 83 to 85, and other functional components such as a terminal block 87 are fixed and attached to the base 86. Further, another circuit board such as a control board (not illustrated) may be attached to the printed circuit board 3 via a connector (not illustrated).

### [Second Embodiment]

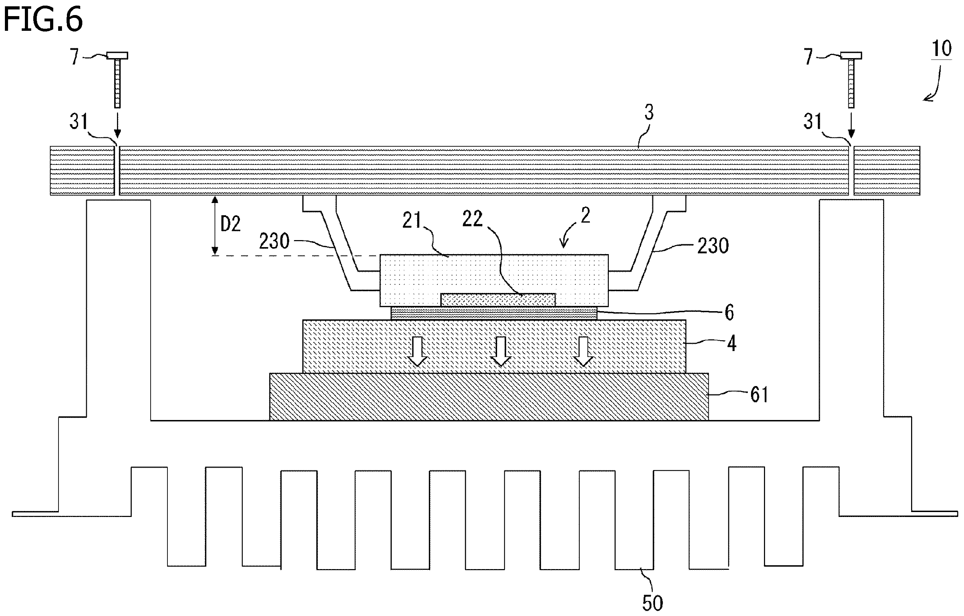

Next, a mounting board 10 according to a second embodiment of the present invention will be described with reference to FIG. 6. The mounting board 10 has many components in common with the mounting board 1 of the first embodiment, and such components are denoted by the same reference numerals and will not be described again. Further, the power conditioner 8 of the first embodiment can be equipped with the configuration of the mounting board 10.

### <Configuration of Mounting Board>

FIG. 6 is a schematic cross-sectional view of the mounting board 10 according to the second embodiment of the present invention, illustrating how the printed circuit board 3 with the electronic component 2 mounted thereon is screwed to a heat sink 50. As compared with the lead 23 illustrated in FIG. 2, a lead 230 is longer in the thickness direction of the electronic component 2, and the electronic component 2 is mounted on the printed circuit board 3 such that a gap of a distance D2 is formed. Similarly to the mounting board 1 illustrated in FIG. 2, a force generated due to screwing the printed circuit board 3 (arrows illustrated in FIG. 6 indicate the force) is preferentially absorbed by the second insulating member 61, and thus deformation of the lead 230 is suppressed. Thus, reduction of the distance D2 due to deformation of the lead 230 is suppressed. As a result, it is possible to prevent the electronic component from being damaged by strain in the printed circuit board 3 and the lead 230 caused by contact between the printed circuit board 3 and the electronic component 2. Note that reduction of the insulation distance is suppressed as in the mounting board 1 illustrated in FIG. 2.

For the mounting board 10 according to the second embodiment of the present invention, results of comparative evaluations in terms of thermal resistance and strain in the printed circuit board 3 by using different characteristic values of the first insulating member 6 and the heat spreader 4 indicate tendencies similar to those shown in FIG. 3A, FIG. 3B and FIG. 4A, FIG. 4B.

### <Supplement 1>

Amounting board (1, 10), including,
an electronic component including an electronic element, a package (21) surrounding the electronic element, and a heat dissipation pad (22) having heat dissipation ability, a printed circuit board (3), the electronic component being mounted on the printed circuit board via a terminal (23, 230) connected to an external circuit,
a heat spreader (4) including a metal as a main component, heat generated in the electronic component being transferred to the heat spreader, and a heat dissipation component (5, 50) including a metal as a main component, heat from the heat spreader being further transferred to the heat dissipation component to be dissipated into air, in which
a first insulating member (6) and a second insulating member (61) each being an insulator are arranged between the electronic component and the heat spreader and between the heat spreader and the heat dissipation component, respectively, and a hardness of the first insulating member and a hardness of the second insulating member are lower than a hardness of the heat spreader.

### REFERENCE SIGNS LIST

1, 10 : Mounting board
2 : Electronic component
21 : Package
22 : Heat dissipation pad
23, 230 : Lead
3 : Printed circuit board
31 : Screw hole
4 : Heat spreader
5, 50 : Heat sink
6 : First insulating member
61 : Second insulating member
7 : Screw
71 : Second screw
8 : Power conditioner
81 : Housing
82 : Metal base
83 to 85 : Spacer
86 : Base
87 : Terminal block

## Claims

1. A mounting board, comprising:
an electronic component including an electronic element, a package surrounding the electronic element, and a heat dissipation pad having heat dissipation ability;
a printed circuit board, the electronic component being mounted on the printed circuit board via a terminal connected to an external circuit;
a heat spreader including a metal as a main component, heat generated in the electronic component being transferred to the heat spreader; and
a heat dissipation component including a metal as a main component, heat from the heat spreader being further transferred to the heat dissipation component to be dissipated into air, wherein
a first insulating member and a second insulating member each being an insulator are arranged between the electronic component and the heat spreader and between the heat spreader and the heat dissipation component, respectively, and
a hardness of the first insulating member and a hardness of the second insulating member are lower than a hardness of the heat spreader.

2. The mounting board according to claim 1, wherein the hardness of the first insulating member according to Asker C hardness standard is in a range from Asker C 5 to Asker C 50.

3. The mounting board according to claim 1 or 2, wherein the first insulating member has a thickness in a range from 0.2 mm to 0.8 mm.

4. The mounting board according to any one of claims 1 to 3, wherein an area of the heat spreader is 2 times or more and 7 times or less an area of the heat dissipation pad.

5. The mounting board according to any one of claims 1 to 4, wherein a thermal conductivity of the first insulating member is higher than a thermal conductivity of the second insulating member.

6. The mounting board according to any one of claims 1 to 5, wherein the first insulating member has a thermal conductivity in a range from 3 W/mK to 20 W/mK.

7. The mounting board according to any one of claims 1 to 6, wherein the heat spreader has a thickness in a range from 0.3 mm to 1.0 mm.

8. The mounting board according to any one of claims 1 to 7, wherein the first insulating member is connected to the heat dissipation pad of each of a plurality of the electronic components.

9. An electric apparatus that performs power conversion of power supplied from a power supply device, wherein
the electric apparatus is equipped with the mounting board according to any one of claims 1 to 8.
